**Europäisches Patentamt**

**European Patent Office**

**Office européen des brevets**

(19)

(11) Veröffentlichungsnummer: **0 119 561**

**B1**

# (12) EUROPÄISCHE PATENTSCHRIFT

(45) Veröffentlichungstag der Patentschrift:
23.11.88

(21) Anmeldenummer: 84102573.7

(22) Anmeldetag: 09.03.84

(51) Int. Cl.⁴: **H 03 J 3/32**, H 03 J 7/06

(54) Verfahren zum Abstimmen der Schwingkreise eines Nachrichtenempfangsgerätes.

(30) Priorität: 11.03.83 DE 3308690

(43) Veröffentlichungstag der Anmeldung:
26.09.84 Patentblatt 84/39

(45) Bekanntmachung des Hinweises auf die Patenterteilung:
23.11.88 Patentblatt 88/47

(84) Benannte Vertragsstaaten:
AT BE CH DE FR GB IT LI LU NL SE

(56) Entgegenhaltungen:
DE-A-2 201 221
DE-A-2 854 852
US-A-4 334 323

NACHRICHTEN ELEKTRONIK, Nr. 11, November 1979, Seiten 365-368, Heidelberg, DE; H. RINERLE u.a.: "Integrierte Schaltkreise für Rundfunkempfänger mit elektronischer Senderwahl"

(73) Patentinhaber: Deutsche Thomson- Brandt GmbH, Hermann- Schwer- Strasse 3 Postfach 1307, D-7730 Villingen- Schwenningen (DE)

(72) Erfinder: Maier, Gerhard, Reutestrasse 19, D-7735 Dauchingen (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

**Beschreibung**

Die Erfindung geht aus von einem Verfahren zum Abstimmen der Schwingkreise eines Nachrichtenempfangsgerätes, insbesondere für Fernseh- und Rundfunkgeräte mit einer Oszillatorschaltung unter Verwendung eines PLL-Abstimmsystems und einer Mischstufe zur Erzeugung einer Zwischenfrequenz, wobei nach Anwahl eines Empfangskanals von dem Mikroprozessor ein Zusatzoszillator mit fester Frequenz ($f_D$) eingeschaltet wird, der mit der vom Empfängeroszillator abgegebenen Oszillatorfrequenz ($f_o$) über eine zusätzliche Mischstufe drei Frequenzen ($f_o$, $f_o + f_D$, $f_o - f_D$) erzeugt, die an den Antenneneingang des Empfängers gelegt werden, die nach dem Abstimmvorgang wieder abgeschaltet werden und beim Abstimmen des Empfangsgerätes die einzelnen Filterkreise nacheinander mit Hilfe von schrittweise veränderbaren von einem Mikroprozessor über Digital-Analog-Wandler erzeugten Abstimmspannungen auf optimale Werte abgeglichen und die ermittelten Abstimmwerte Kapazitätsvariationsdioden der einzelnen Filterkreise zugeordnet werden.

Es ist z. B. eine Abstimmeinheit bekannt (DE-A-2 854 852), die automatisch die Hochfrequenzkreise abstimmt unter Verwendung eines PLL-Abstimmsystems und dreier Hilfsoszillatoren und diesen zugeordneten Analogspeichern. Hierbei sind der Zahl der abzugleichenden Hochfrequenzkreise entsprechende Hilfsoszillatoren notwendig. Die Zahl der benötigten Hilfsoszillatoren und somit der Materialaufwand erhöht sich dann in besonderem Maße, wenn z. B. beim Abgleich eines Fernsehempfängers Band I, Band III und die Bänder IV und V abgeglichen werden sollen. Es besteht dabei die Gefahr von Mehrdeutigkeiten zwischen den Frequenzen des Tuneroszillators, der Hilfsoszillatoren und den Empfangsfrequenzen. Nachteilig für eine praktikable Realisierung der vorgeschlagenen Abstimmeinheit ist, daß die Erregerwicklungen der Hilfsoszillatoren mit den einzelnen Spulen in den Hochfrequenzkreisen unerwünschte Resonanzen und Bedämpfungen der Kreise hervorrufen können, die auch noch eine unkontrollierbare Verstimmung der Kreise verursachen, wenn die Hilfsoszillatoren nach erfolgtem Abgleich abgeschaltet sind. Außerdem sind Analogspeicher vorgesehen, die in zeitlichen Abständen nachgeladen werden müssen, um die optimale Abstimmwerte zu erhalten. Aus diesen Gründen ist prinzipbedingt ein optimaler Abgleich des Empfangsgerätes nicht erreichbar. Außerdem werden durch das sich laufend wiederholende Nachstimmen Störungen auf dem Bildschirm oder im Lautsprecher sichtbar bzw. hörbar.

In der Zeitschrift "Nachrichten elektronik" Heft 11/79, Seiten 365-368 wird ein Abstimmverfahren für Rundfunkempfänger beschrieben, das ebenfalls zusätzliche Hilfskreise in den Hochfrequenzfiltern anwendet. Auch hier ergeben sich nachteilige Beeinflussungen der Kreise im Betrieb des abgeglichenen Empfängers. Wie auf Seite 367 linke und mittlere Spalte angegeben, wird die Genauigkeit der Abstimmungen durch Spezialbauteile nur in Form von exakt gepaarten Dioden erzielt. Auch dieses erfordert einen nicht außer acht zu lassenden Aufwand.

Es ist auch bekannt, einen Hochfrequenzempfänger automatisch abzugleichen, indem von einem Mikroprozessor gesteuert das Vorkreisfilter und die Zwischenkreisfilter mit Hilfe einer am Antenneneingang eingespeisten Hilfsfrequenz abgeglichen werden. Diese Hilfsfrequenz wird durch Mischung in einer zusätzlichen Mischstufe einer fest eingestellten Frequenz eines Zusatzoszillators mit der Frequenz des Überlagerungsoszillators des Empfängers gewonnen. (US-A-4 334 323). Bei diesem automatischen Abgleichvorgang wird die Antenne vom Eingang des Empfängers abgetrennt. Dazu ist ein besonderer Schalter notwendig. Maßnahmen zur Beseitigung von Störungen durch die Oszillatorfrequenz oder Spiegelfrequenz sind nicht vorgesehen.

Der Erfindung liegt die Aufgabe zugrunde, einen automatischen Selbstabgleich eines Empfangsgerätes zu ermöglichen, mit welchem auch störende Spiegelfrequenzen und Störungen der Empfängeroszillatorfrequenzen auf ein Minimum reduziert werden. Diese Aufgabe wird durch die Maßnahme des Patentanspruchs gelöst. Weitere Vorteile ergeben sich aus den in den Unteransprüchen angegebenen Maßnahmen.

Das angemeldete Verfahren besitzt den Vorteil, daß durch die Auswertung des erzeugten ZF-Signals an einem sehr schmalbandigen Filterkreis ein optimaler Abgleich erzielbar ist. Während des Abgleichs brauchen die Antennensignale nicht abgeschaltet zu werden. Durch die angegebenen Maßnahmen werden die postalischen Störstrahlbedingungen eingehalten. Die Abgleichzeit ist dabei sehr kurz.

Nachstehend soll an einem Ausführungsbeispiel mit Hilfe der Zeichnung das Wesentliche der Erfindung am Beispiel eines Fernsehempfangsgerätes erläutert werden.

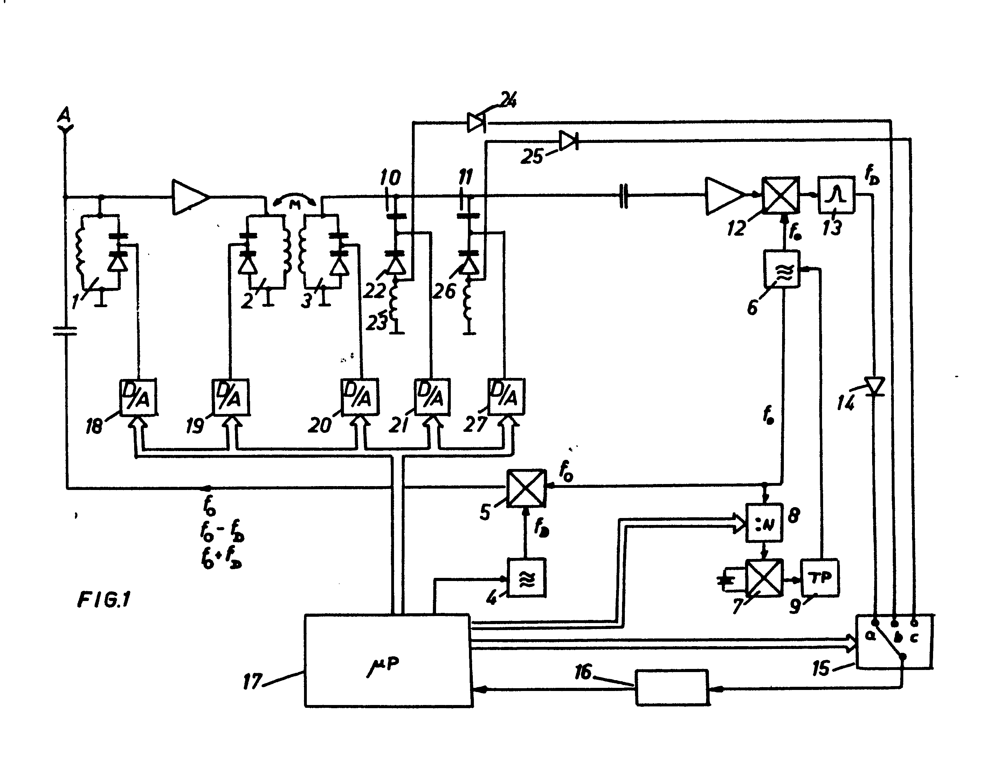

Figur 1      zeigt ein Blockschaltbild zur Erläuterung des Verfahrens

Figur 2      zeigt Frequenzspektren zur Erläuterung der Figur 1.

Mit 1, 2 und 3 sind die HF-Filterkreise eines Empfangsgerätes bezeichnet, die durch das nachstehend beschriebene Verfahren beim Einstellen auf eine Empfangsfrequenz automatisch abgeglichen werden sollen. Für diesen Abgleich wird ein Zusatzoszillator 4 eingeschaltet, der eine feste Frequenz $f_D$ erzeugt, welche in einer zusätzlichen Mischstufe 5 mit der vom Empfängeroszillatar 6 erzeugten Oszillatorfrequenz $f_o$ gemischt wird. Der

Empfängeroszillator 6 wird bei Anwenden eines Kanals mit Hilfe der FLL-Schaltung 7, 8, 9 auf die dem Kanal zugeordnete Oszillatorfrequenz fo eingestellt. Die Mischstufe 5 erzeugt aus den Freuqenzen $f_D$ und fo drei Frequenzen fo, fo$+f_D$ und fo-$f_D$ die an den Antenneineingang gelegt werden. Die in der Empfangseinrichtung befindlichen Saugkreise 10 und 11 deren Zweck später erläutert wird, werden zunächst durch Anlegen einer maximalen Abstimmspannung VTmax außer Funktion gebracht. Die erzeugten drei Frequenzen fo, fo$+f_D$ und fo-$f_D$ werden mit einer Spannung kleiner als 44 dBμv an den Antenneneingang gelegt. Dabei können sämtliche Empfangssignale ebenfalls am Antenneneingang anliegen und brauchen nicht abgeschaltet zu werden. Nun werden die Kreise 1, 2 und 3 nacheinander auf Maximum am ZF-Ausgang abgeglichen. Hierbei entsteht durch die Empfängeroszillatorfrequenz fo und durch den Mischer 12 eine ZF-Spannung, welche über einen schmalbandigen Kreis 13 ausgesiebt und ausgewertet wird. Die 3-dB-Bandbreite dieses Kreises sollte 1 MHz betragen. Über eine Diode 14 gelangt das erzeugte Signal über einen Schalter 15 a an eine Auswertestufe 16, welche bei Feststellen eines maximalen Eingangswertes ein Signal an den Mikroprozessor 17 abgibt. Die über die Digital-Analog-Wandler 18, 19 und 20 erzeugten Abstimmspannungen werden festgehalten und z. B. in einem Speicher abgelegt.

Nach diesem Abgleichvorgang wird, vom Mikroprozessor 17 gesteuert, der Schalter 15 auf die nächste Stellung b gebracht. Hierauf erfolgt ein Abgleichvorgang des Saugkreises 10, der z. B. auf die Oszillatorfrequenz fo des Empfängers abgestimmt werden soll. Die Abstimmwerte gelangen über den Digital-Analog-Wandler 21 an die Kapazitätsdiode 22 des Saugkreises 10. Die Spannung wird an der Saugkreisspule 23 abgegriffen und über eine Diode 24 über den Schalter 15 b an die Auswertschaltung 16 gebracht. Ein gleicher Vorgang erfolgt für die synthetisch erzeugte Spiegelfrequenz (N+1) für VHF mit dem Wert 2fo-($f_B$+fr)/2 MHz mit Hilfe des Saugkreises 11 über die Diode 25, wobei die Schaltstufe 15 auf den Kontakt c geschaltet wird. Die entsprechende durch die Mischstufe 5 künstlich erzeugte Spiegelfrequenz fs liegt am Antenneneingang. Die Abstimmspannung für die Kapazitätsdiode 26 wird dieser über den Digital-Analog-Wandler 27 zugeführt. Beim Abgleich auf UHF-Kanäle geschieht der gleiche Vorgang mit einem entsprechendem auf die Spiegelfrequenz (N+9) abzustimmenden Gangkreis (nicht dargestellt). Während des Abgleichs der Saugkreise 10 und 11 werden die HF-Filterkreise 1 - 3 auf eine maximale Abstimmspannung $VT_{maw}$ geschaltet. Nach dem automatischen Abgleich wird der Zusatzoszillator 4 mit Mischstufe 5 wieder abgeschaltet.

Beim Abgleich des mehrkreisigen Bandfilters 2, 3 wird der nicht am Abgleich beteiligte Kreis 2 oder 3 verstimmt. Das geschieht in der Wiese, daß im unteren Abstimmspannungsbereich bei kleiner oder gleich VTmax/2 für den abzugleichenden Kreis an die Kapazitätsdiode des auszuschaltenden anderen Kreises die maximal mögliche Abstimmspannung VTmax gelegt wird und im oberen Abstimmspannungsbereich bei größer VTmax/2 für den abzugleichenden Kreis die Kapazitatsdiode des auszuschaltenden anderen Kreises die minimale Abstimmspannung VTmin gelegt wird.

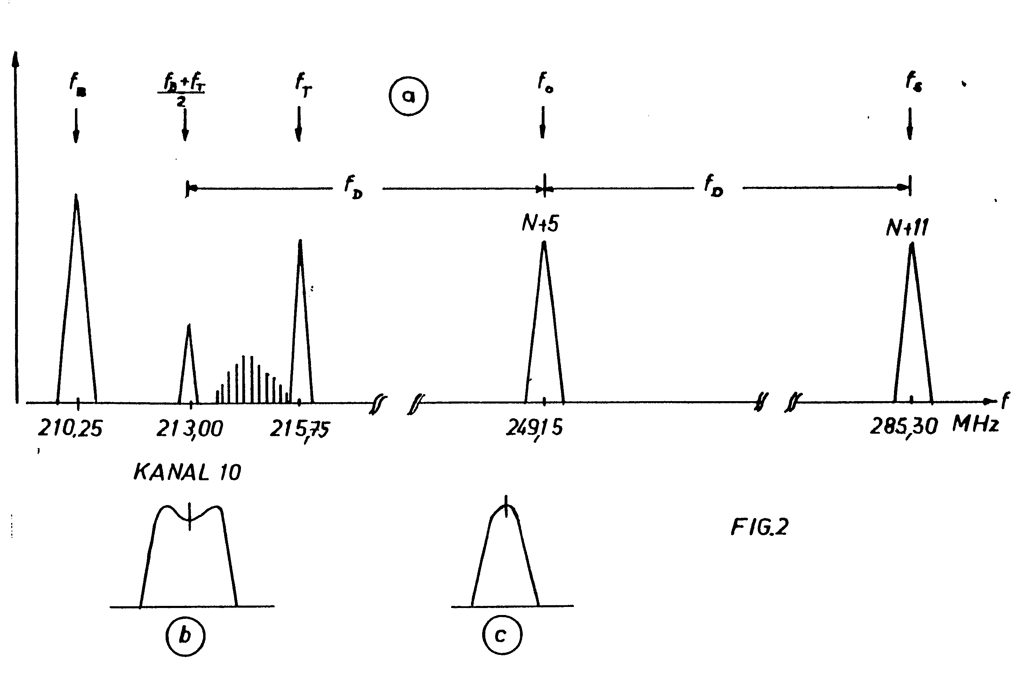

In Figur 2a sind die Verhältnisse am Beispiel des Fernsehempfangskanals 10 graphisch aufgetragen. Die Frequenz des Bildträgers liegt bei 210,25 MHz und die des Tonträgers bei 215,75 MHz. Die Oszillatorfrequenz wird auf 249,15 MHz eingestellt. Das Verfahren des soeben beschriebenen Abstimmsystems erzeugt mit Hilfe des Zusatzoszillators 4 über die Mischstufe 5 die Frequenzen fo (249,15 MHz), fo+fo (285,30 MHz), fo-fo (213 MHz) die sich aus der Mischung mit der Oszillatorfrequenz fo des Empfängeroszillators 6 ergeben. Am Ausgang der Mischstufe 12 der Empfängerschaltung ergibt sich eine Zwischenfrequenz von 36,15 MHz, die schmalbandig ausgesiebt und ausgewertet wird. Die Frequenz von 285,30 MHz entspricht etwa der Spiegelfrequenz (N+11) des Kanals 10. In Figur 2b ist die HF-Kreisdurchlasskurve aufgetragen, die sich nach dem Abgleich des Empfängers am Ausgang ergibt.

Figur 2c stellt die Durchlasscharakteristik des Filterkreises 13 dar.

## Patentansprüche

1. Verfahren zum Abstimmen der Schwingkreise eines Nachrichtenempfangsgerätes, insbesondere für Fernseh- und Rundfunkgeräte mit einer Oszillatorschaltung unter Verwendung eines PLL-Abstimmsystems und einer Mischstufe zur Erzeugung einer Zwischenfrequenz, wobei nach Anwahl eines Empfangskanals von dem Mikroprozessor ein Zusatzoszillator mit fester Freqeunz ($f_D$) eingeschaltet wird, der mit der vom Empfängeroszillator abgegebenen Oszillatorfrequenz (fo) über eine zusätzliche Mischstufe drei Frequenzen (fo, fo$+f_D$, fo-$f_D$) erzeugt, die an den Antenneneingang des Empfängers gelegt werden, die nach dem Abstimmvorgang wieder abgeschaltet werden und beim Abstimmen des Empfangsgerätes die einzelnen Filterkreise nacheinander mit Hilfe von schrittweise veränderbaren von einem Mikroprozessor über Digital-Analog-Wandler erzeugten Abstimmspannungen auf optimale Werte abgeglichen und die ermittelten Abstimmwerte Kapazitätsvariationsdioden der einzelnen Filterkreise zugeordnet werden, dadurch gekennzeichnet, daß die Frequenz ($f_D$) des Zusatzoszillators (4) derart gewählt ist, daß sie bei Empfangssignalen mit einem einzigen Träger der Gleichung $f_D$ = fo - fe entspricht, wobei (fo) die Oszillatorfrequenz und (fe) die Empfangsfrequenz darstellt und daß sie bei Empfangssignalen mit zwei Trägern der Gleichung $F_D$ = fo-$(f_B + f_T)$/2 entspricht, wobei (fo) die Oszillatorfrequenz und $(F_B)$ und $(f_T)$ die beiden Empfangsfrequenzen darstellen und daß bei den mehrkreisig gekoppelten Hochfrequenzfiltern (2, 3) der am Abgleich nicht beteiligte Schwingkreis derart verstimmt wird, daß er ausserhalb der Frequenz (fo-$f_D$) liegt, wobei eine am Ausgang der Mischstufe (12) der Empfangseinrichtung über ein auf die Frequenz (fo) des Zusatzoszillators (4) abgestimmtes schmalbandiges Filter (13) abgenommene Spannung an eine Auswerteschaltung (16) gelangt, welche bei Erreichen einer an dieser auftretenden maximalen Eingangsspannung eine weitere Veränderung der Abstimmung des gerade abzustimmenden Schwingkreises durch den Mikroprozessor unterbricht und daß nach diesem Abgleich die erzeugte veränderbare Abstimmspannung an einen auf die Spiegelfrequenz des angewählten Kanals abzustimmenden Saugkreis (10) geschaltet wird, wobei die Auswerteschaltung (16) bei optimalem Abgleich des Saugkreises (10) die Abstimmspannung für diesen mittels eines Digital-Analog-Wandlers (21) festhält und daß danach derselbe Abgleichvorgang für einen auf die Oszillatorfrequenz (fo) vorgesehenen Saugkreis (11) erfolgt, wobei während des Abgleichvorgangs der Saugkreise (10, 11) die HF-Filterkreise (1, 2, 3) auf die maximale Abstimmspannung geschaltet werden.

2. Verfahren nach Anspruch 1, dadurch gekennzeichnet, daß die Verstimmung des gerade am Abgleich nicht beteiligten Schwingkreises bei den mehrkreisig gekoppelten Hochfrequenzfiltern derart erfolgt, daß im unteren Abstimmspannungsbereich bei ($\leqslant V_{Tmax}$/2) für den abzugleichenden Kreis an die Kapazitätsdiode des auszuschaltenden anderen Kreises die maximal mögliche Abstimmspannung $(V_{Tmax})$ gelegt wird und im oberen Abstimmspannungsbereich bei ($> V_{Tmax}$/2) für den abzugleichenden Kreis an die Kapazitätsdiode des auszuschaltenden anderen Kreises die minimale Abstimmspannung ($V_{Tmin}$) gelegt wird.

3. Verfahren nach Anspruch 1, dadurch gekennzeichnet, daß die Feststellung eines optimalen Abgleiches der Saugkreise die die störende Oszillatorfrequenz am Antenneneingang und die Spiegelfrequenz vor dem Tunermischer unterdrücken sollen, durch Maximummessung der Spannung an der Saugkreisspule erfolgt.

4. Verfahren nach Anspruch 1, dadurch gekennzeichnet, daß die dem Antenneneingang zugeführte Spannung kleiner ist als 44 dBµV.

5. Verfahren nach Anspruch 1, dadurch gekennzeichnet, daß die Tunerregelungsspannung während des automatischen Ableichvorgangs abgeschaltet wird.

6. Verfahren nach Anspruch 1, dadurch gekennzeichnet, daß der Abgleichvorgang der Schwingkreise mit steigender Abstimmspannung erfolgt.

7. Verfahren nach Anspruch 1, dadurch gekennzeichnet, daß der schmalbandige ZF-Auswertfilterkreis eine 3-dB-Bandbreite von kleiner oder gleich 1 MHz besitzt.

**Claims**

1. A method for tuning the resonating circuits of a communication receiver, in particular of television and radio sets, comprising an oscillator circuit using a phase-locked tuning system and a mixing stage for generating an intermediate frequency, whereby after selection of a receiving channel a booster oscillator of fixed frequency $(f_D)$ is connected by the microprocessor, which generates three frequencies (fo, fo + $f_D$, fo-$f_D$) with the oscillator frequency (fo) delivered by the receiver oscillator via an additional mixing stage, which are impressed on the aerial input of the receiver and are disconnected again after the tuning is over and whereby during the tuning of the receiver the filter circuits are balanced in succession to optimal values with the aid of gradually changeable tuning voltages generated by a microprocessor via digital-analog converters, and the established tuning values are associated with varactors of the filter circuits, characterised in that the frquency $(f_D)$ of the booster oscillator (4) is selected so that it agrees with the equation $f_D$ = fo - fe, for incoming signals having a single carrier, where (fo) is the oscillator frequency and (fe) the receiving frequency, and that it agrees with the equation $F_D$ = fo - $(f_B + f_T)$/2 for incoming signals having two carriers, where (fo) is the oscillator frquency and $(F_B)$ and $(f_T)$ the two receiving frequencies, and that with the multi-circuit-coupled high-frequency filters (2, 3) the resonating circuit not taking part in the balancing is detuned so that it is outside of the frequency (fo-$f_D$), so that a voltage taken at the output of the mixing stage (12) of the receiver by a narrow-band filter (13) tuned to the frequency (fo) of the booster oscillator (4) reaches an evaluating circuit (16), which when a maximum input voltage is reached at the said evaluating circuit interrupts a further alteration of the tuning of the resonating circuit about to be tuned by the microprocessor, and that after this balancing the generated variable tuning voltage is switched to the acceptor circuit (10) to be tuned to the image frequency of the selected channel, whereby the evaluating circuit (16) during optimal balancing of the acceptor circuit (10) maintains the tuning voltage for this by means of a digital-analog converter (21), and that after this the same balancing operation takes place for an acceptor circuit (11) provided for the oscillator frequency (fo), whereby during the balancing process of the acceptor circuits (10, 11)

the HF filter circuits (1, 2, 3) are switched to the maximum tuning voltage.

2. A method as claimed in Claim 1, characterized in that the detuning of the resonating circuit which has just not participated in the balancing for the multi-circuit coupled high-frequency filters is effected so that in the bottom tuning voltage range of ($< = V_{Tmax}/2$) for the circuit to be balanced the maximum possible tuning voltage ($V_{Tmax}$) is impressed on the varactor of the other circuit to be disconnected, and in the top tuning voltage range of ($> V_{Tmax}/2$) the minimum tuning voltage ($V_{Tmin}$) is impressed on the varactor of the other circuit to be disconnected for the circuit which is to be balanced.

3. A method as claimed in Claim 1, characterized in that the fixing of an optimal balancing of the acceptor circuits, which are to suppress the disturbing oscillator frequency at the aerial input and the image frequency before the tuner mixer, is effected by maximum measurement of the voltage at the acceptor circuit coil.

4. A method as claimed in Claim 1, characterised in that the voltage fed to the aerial input is less than 44 dBμV.

5. A method as claimed in Claim 1, characterized in that the tuner control voltage is disconnected during the automatic balancing process.

6. A method as claimed in Claim 1, characterized in that the balancing process of the resonating circuits is effected with rising tuning voltage.

7. A method as claimed in Claim 1, characterized in that the narrow-band intermediate-frequency evaluating filter circuit has a 3 dB band width of less than or equal to 1 MHz.

**Revendications**

1. Procédé pour syntoniser les circuits oscillants d'un appareil de réception d'informations notamment pour des appareils de télévision et de radiodiffusion comportant un circuit oscillateur, moyennant l'utilisation d'un système de syntonisation à boucle PLL et d'un étage mélangeur pour produire une fréquence intermédiaire, et selon lequel, après la sélection d'un canal de réception par le microprocesseur, un oscillateur additionnel délivrant une fréquence fixe ($f_D$) est branché, cet oscillateur produisant, à partir de la fréquence d'oscillation (fo) délivrée par l'oscillateur du récepteur, au moyen d'un étage mélangeur supplémentaire, trois fréquences (fo, fo+$f_D$, fo-$f_D$) qui sont envoyées à l'entrée de l'antenne du récepteur et sont à nouveau supprimées après l'opération de syntonisation et selon lequel, lors de la syntonisation de l'appareil de réception, on règle successivement les différents circuits de filtre à l'aide de tensions de syntonisation pouvant être modifiées pas-à-pas et produites par un microprocesseur par l'intermédiaire de convertisseurs numérique/analogique, et on associe les valeurs de syntonisation déterminées à des diodes à capacité variable des différents circuits de filtre, caractérisé en ce qu'on choisit la fréquence ($f_D$) de l'oscillateur additionnel (4) de manière qu'elle corresponde, dans le cas de signaux de réception possédant une seule fréquence porteuse, à la relation $f_D = fo-f_e$, ($f_o$) représentant la fréquence de l'oscillateur et (fe) la fréquence de réception, et de manière qu'elle corresponde, dans le cas de signaux de réception possédant deux fréquences porteuses, à la relation $F_D = fo-(f_B+f_T)/2$, (fo) représentant la fréquence de l'oscillateur et ($F_B$) et ($f_T$) représentant les deux fréquences de réception, et que dans le cas des filtres à haute fréquence (2, 3) accouplés selon plusieurs circuits, on désaccorde le circuit oscillant ne participant pas au réglage de manière qu'il se situe en dehors de la fréquence (fo-$f_D$), auquel cas une tension prélevée sur la sortie de l'étage mélangeur (12) du dispositif de réception par l'intermédiaire d'un filtre à bande étroite (13) syntonisé sur la fréquence (fo) de l'oscillateur additionnel (4) parvient à un circuit d'évaluation (16) qui, lorsqu'une tension d'entrée maximale apparaissant dans ce circuit est atteinte, interrompt une modification ultérieure de la syntonisation des circuits oscillants devant être précisément syntonisés, par le microprocesseur et qu'après ce réglage, on applique la tension de syntonisation variable produite à un circuit d'absorption (10) devant être syntonisé sur la fréquence image du signal sélectionné, auquel cas, lors d'un réglage optimal du circuit d'absorption (10), le circuit d'évaluation (16) maintient la tension de syntonisation pour ce circuit à l'aide d'un convertisseur numérique/analogique (21) et qu'ensuite le même processus de réglage est mis en oeuvre pour un circuit d'absorption (1) prévu pour la fréquence d'oscillateur (fo), auquel cas pendant le processus de réglage des circuits d'absorption (10, 11), les circuits de filtre à haute fréquence (1, 2, 3) sont raccordés à la tension de syntonisation maximale.

2. Procédé selon la revendication 1, caractérisé en ce que le désaccord du circuit oscillant ne participant précisément pas à la syntonisation dans le cas où les filtres à haute fréquence sont accouplés selon plusieurs circuits s'effectue de telle sorte que dans la gamme inférieure des tensions de syntonisation ($V_{Tmax}/2$) pour le circuit devant être réglé, la tension maximale possible de syntonisation ($V_{Tmax}$) est appliquée à la diode capacitive de l'autre circuit devant être débranché et que dans la gamme supérieure des tensions de syntonisation ($V_{Tmax}/2$) pour le circuit devant être réglé, la tension minimale de syntonisation ($V_{Tmin}$) est appliquée à la diode capacitive de l'autre circuit devant être débranché.

3. Procédé selon la revendication 1, caractérisé en ce que la détermination d'un réglage optimal des circuits d'absorption, qui doivent supprimer la fréquence parasite de l'oscillateur présente à l'entrée de l'antenne et la fréquence symétrique présente en amont du mélangeur du syntoniseur, est réalisée au moyen de la mesure du maximum de la tension dans la bobine des circuits d'absorption.

4. Procédé selon la revendication 1, caractérisé en ce que la tension envoyée à l'entrée de l'antenne est inférieure à 44 dBµV.

5. Procédé selon la revendication 1, caractérisé en ce que la tension de régulation du syntoniseur est interrompue pendant l'opération automatique de réglage.

6. Procédé selon la revendication 1, caractérisé en ce que l'opération de réglage des circuits oscillants est réalisée avec une tension de syntonisation croissante.

7. Procédé selon la revendication 1, caractérisé en ce que le circuit de filtre d'évaluation à bande étroite et à moyenne fréquence possède une largeur de bande de 3 dB inférieure ou égale à 1 MHz.

FIG.1

0 119 561

FIG.2